# DEMANDE DE BREVET EUROPEEN

(11) **EP 1 914 892 A1**
(43) Date de publication de la demande: **23.04.2008**
(21) Numéro de dépôt: 07118605.0
(22) Date de dépôt: 16.10.2007
(51) Int. Cl.: H03K 19/003, H03K 19/017, H03K 17/16

(54) **Dispositif d'interfaçage de sortie compensé en charge et circuit électronique correspondant**

(30) Priorité: 20.10.2006 FR 0609246
(71) Demandeur: ATMEL NANTES SA, 44306 Nantes Cédex 3 (FR)
(72) Inventeur: Bendraoui, Abdellatif, 44450, SAINT-JULIEN DE CONCELLES (FR); Chatal, Joël, 44470, CARQUEFOU (FR); Gibet, Stanislas, 44470, CARQUEFOU (FR)
(74) Mandataire: Guéné, Patrick Lucien Juan Joseph

(57) **Abrégé**

L'invention concerne un dispositif d'interfaçage de sortie recevant en entrée (1) un signal d'entrée (SIN) et délivrant en sortie (2), à une charge externe (C1), un signal de sortie (SOUT).

Selon l'invention, un tel dispositif (500) comprend des moyens d'inversion (51) de l'effet de la capacité de la charge externe (C1) sur la pente (en Anglais « slew rate ») du signal de sortie (SOUT).

## Description

### 1. Domaine de l'invention

Le domaine de l'invention est celui des circuits électroniques intégrés et plus particulièrement des circuits d'interface de sortie (ou « output buffers » en anglais) (aussi appelés par la suite dispositifs d'interfaçage de sortie).

De tels dispositifs d'interfaçage sont bien connus de l'art antérieur. Ils sont généralement placés à la périphérie d'un circuit intégré et sont utilisés pour interfacer des signaux électriques depuis le coeur du circuit vers l'extérieur du circuit.

Plus précisément, l'invention concerne le contrôle de la pente maximale du signal de sortie (ou « slew rate » en anglais) de tels dispositifs d'interfaçage.

### 2. Solutions et inconvénients de l'art antérieur

On discute ci-après les inconvénients de l'art antérieur à travers le cas particulier d'un circuit d'interface de type NMOS (c'est-à-dire un circuit d'interface dont le transistor de sortie est du type NMOS).

Sur toutes les figures du présent document, les éléments ou signaux identiques sont désignés par une même référence alphanumérique.

Actuellement, de plus en plus d'équipements électroniques sont équipés de dizaines voire de centaines de circuits d'interface très rapides.

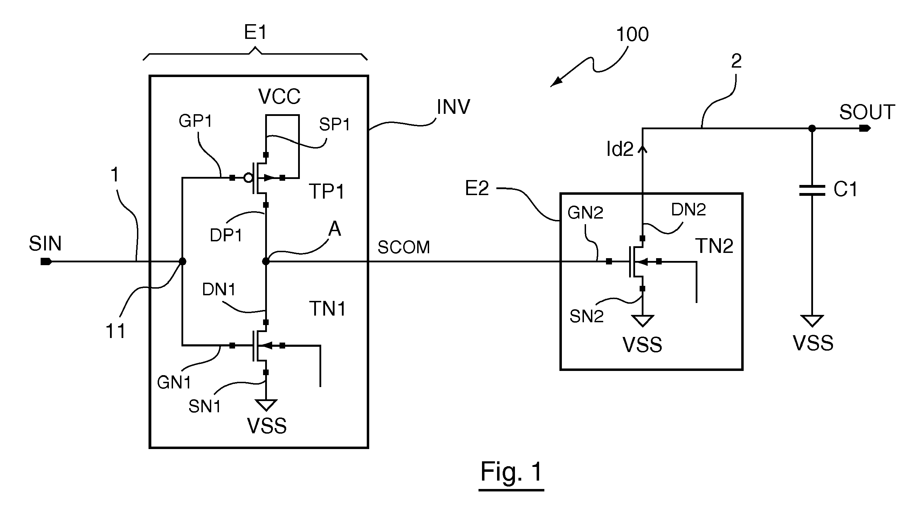

On présente, en relation avec la **figure 1**, le schéma électrique d'un dispositif d'interfaçage de sortie classique, référencé 100 (aussi appelé par la suite premier dispositif d'interfaçage classique).

Par souci de simplification de la description, on se limitera, dans toute la suite de ce document, à décrire le cas particulier des dispositifs d'interfaçage fonctionnant sous des tensions d'alimentation de 0V et 5V. L'Homme du Métier étendra sans difficulté cet enseignement à tout type de tension destinée à alimenter un circuit électronique intégré.

Le dispositif d'interfaçage de sortie 100 reçoit sur une entrée 1 un signal d'entrée SIN et délivre en sortie 2 un signal de sortie SOUT.

Ce dispositif d'interfaçage de sortie 100 comprend un étage E1 de commande, comprenant un inverseur INV, et un étage E2 de sortie, comprenant un transistor de sortie TN2.

Plus précisément, l'inverseur INV reçoit sur une entrée 11 le signal d'entrée SIN et délivre à un point milieu A un signal de commande SCOM. Cet inverseur INV comprend un transistor TP1, dont la source SP1 est reliée à l'alimentation VCC du circuit (aussi appelée niveau logique haut dans la suite de la description) et dont le drain DP1 est relié au point milieu A, et un transistor TN1, dont la source SN1 est reliée au potentiel de référence VSS (aussi appelé niveau logique bas dans la suite de la description) et dont le drain DN1 est relié au drain DP1 du transistor TP1. Les transistors TP1 et TN1 reçoivent sur leur grille GP1 et GN1, le signal d'entrée SIN.

Ainsi, lorsque le signal d'entrée SIN est sensiblement égal au potentiel de référence VSS, le transistor TP1 est rendu passant et le transistor TN1 est rendu bloqué. L'inverseur INV délivre alors au point milieu A un signal de commande SCOM qui est sensiblement égal à l'alimentation VCC.

A l'inverse, lorsque le signal d'entrée SIN est sensiblement égal à l'alimentation VCC, le transistor TN1 est rendu passant et le transistor TP1 est rendu bloqué. L'inverseur INV délivre alors au point milieu A un signal de commande SCOM qui est sensiblement égal au potentiel de référence VSS.

Le transistor de sortie TN2, dont la source SN2 est reliée au potentiel de référence VSS et dont le drain DN2 est relié à la sortie 2, forme un interrupteur commandé par le signal de commande SCOM (appliquée sur la grille GN2).

On décrit ci-après en référence à la figure 1, le fonctionnement du dispositif d'interfaçage de sortie 100 de l'art antérieur. Ce dispositif comprend en sortie une charge capacitive C1 (disposée entre la sortie 2 et le potentiel de référence VSS), aux bornes de laquelle on peut mesurer la pente maximale (ou « slew rate » en anglais) du signal de sortie SOUT.

Lorsque le signal d'entrée SIN passe du potentiel de référence VSS à une tension (sensiblement égale à l'alimentation VCC) de 4V, le signal de commande SCOM (délivré au point milieu A) devient alors sensiblement égal au potentiel de référence VSS, soit 0V. Le transistor de sortie TN2, dont la grille GN2 reçoit le signal de commande SCOM, est donc placé dans un état bloqué (interrupteur ouvert).

En revanche, lorsque le signal d'entrée SIN passe de l'alimentation VCC au potentiel de référence VSS, soit 0V, le signal de commande SCOM (délivré au point milieu A) devient alors sensiblement égal à l'alimentation VCC, soit 5V. Le transistor de sortie TN2, dont la grille GN2 reçoit le signal de commande SCOM, est donc placé dans un état passant (interrupteur fermé), dans lequel il délivre un courant de drain Id2 sur la sortie 2. L'intégralité du courant Id2 charge la capacité de sortie C1. Cette charge s'effectuant à courant constant provoque une commutation très rapide sur la sortie 2 (en d'autres termes, le signal de sortie SOUT présente une forte pente).

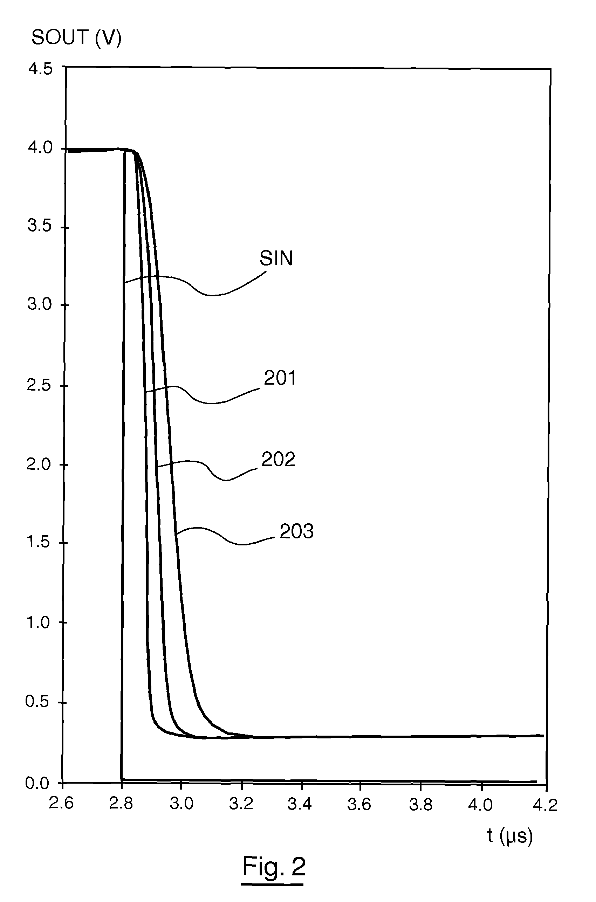

On présente en relation avec la **figure 2**, les performances dynamiques (temps de descente du signal de sortie SOUT mesuré aux bornes de la capacité C1) du dispositif d'interfaçage de sortie 100 de la figure 1 en réponse à un signal d'entrée SIN sous la forme d'un échelon de tension passant d'une tension sensiblement égale à l'alimentation VCC (4V) à VSS (0V).

Plus précisément, la figure 2 présente trois courbes référencées 201 à 203 illustrant la tension (en volts) du signal de sortie SOUT en fonction du temps t exprimé en microsecondes (µs) pour trois valeurs de capacité C1. Ainsi, la courbe référencée 201 correspond à une capacité de 50pF, la courbe référencée 202 correspond à une capacité de 200pF et la courbe référencée 203 correspond à une capacité de 500pF.

Comme l'illustre la figure 2, la rapidité du dispositif d'interfaçage de sortie 100 de l'art antérieur diminue fortement lorsque la charge capacitive en sortie augmente. En effet, si on compare la courbe 201 avec la courbe 203, on constate que ; avec une capacité de 500pF en sortie du dispositif, on met environ dix fois plus de temps pour passer de VCC (état logique haut) à VSS (état logique bas).

L'inconvénient majeur de ce premier dispositif d'interfaçage connu réside donc dans le fait qu'il présente des temps de transition (c'est-à-dire le temps pour passer d'un état logique à l'état logique complémentaire) relativement longs, notamment pour le cas des fortes charges capacitives.

Pour remédier à ce problème de dégradation des performances dynamiques, il est traditionnellement envisagé d'introduire une résistance de contrôle de « slew rate » dans le dispositif d'interfaçage de sortie 100 précité.

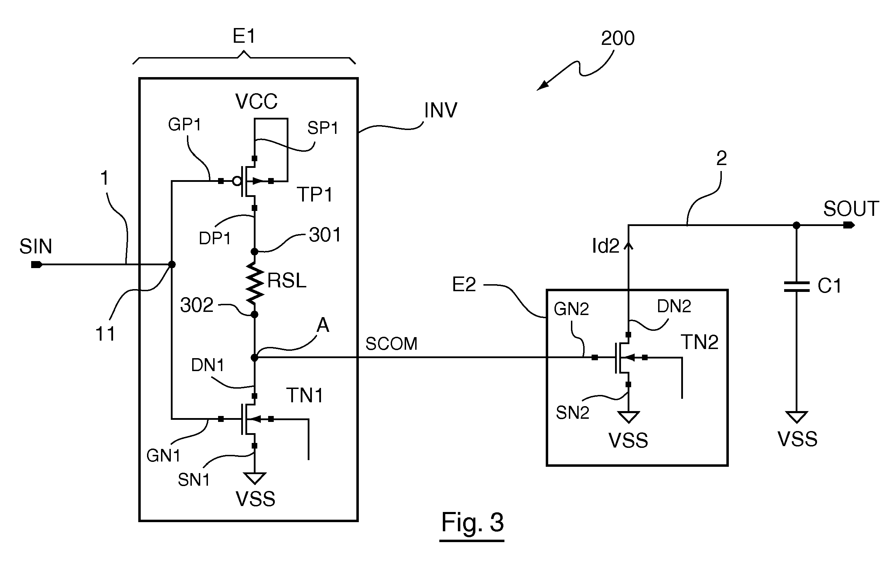

Comme illustré par la **figure 3**, dans le dispositif d'interfaçage de sortie classique, référencé 200 (aussi appelé par la suite second dispositif d'interfaçage classique), la résistance de contrôle RSL est montée en série avec le transistor TP1. Plus précisément, la résistance de contrôle RSL comprend une première extrémité 301 qui est reliée au drain DP1 du transistor TP1 et une seconde extrémité 302 qui est reliée au point milieu A. Cette résistance de contrôle RSL permet de freiner la montée de la tension de grille VGN2 du transistor de sortie TN2. Cette solution permet ainsi de limiter la pente du signal de sortie SOUT.

En effet, lorsque le signal d'entrée SIN passe de VCC à VSS, la capacité de grille (non représentée) du transistor de sortie TN2 se charge à travers le signal de commande SCOM, dont l'effet est la charge de la capacité C1. Ceci a pour conséquence de retarder la commande du transistor de sortie TN2, et donc de retarder la génération du courant Id2 sur la sortie 2.

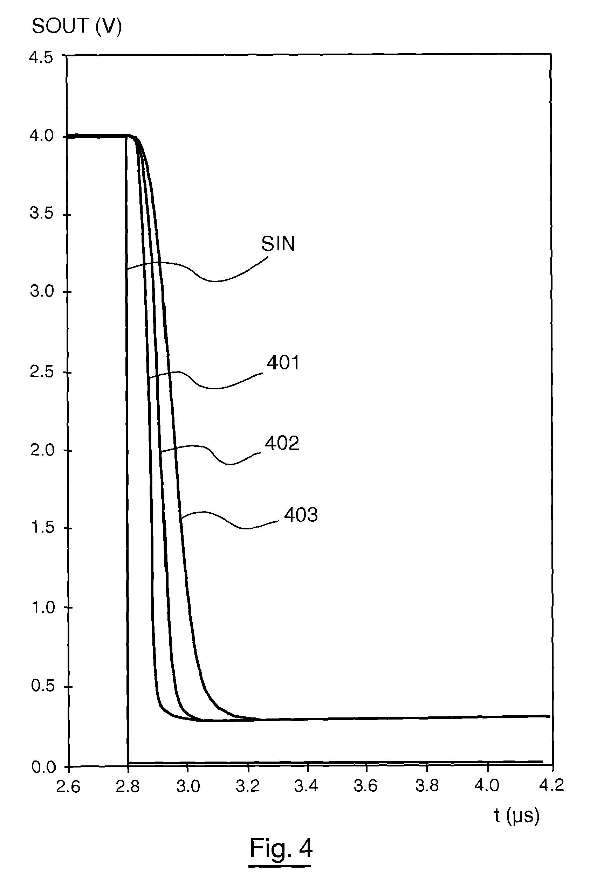

On présente désormais en relation avec la **figure 4**, les performances dynamiques (temps de descente du signal de sortie SOUT mesuré aux bornes de la capacité C1) du dispositif d'interfaçage de sortie 200 de la figure 3 en réponse à un signal d'entrée SIN sous la forme d'un échelon de tension passant d'une tension sensiblement égale à l'alimentation VCC (4V) à VSS (0V).

Plus précisément, la figure 4 présente trois courbes référencées 401 à 403 illustrant la tension (en volts) du signal de sortie SOUT en fonction du temps t exprimé en microsecondes (µs) pour trois valeurs de capacité C1. Ainsi, la courbe référencée 401 correspond à une capacité de 50pF, la courbe référencée 402 correspond à une capacité de 200pF et la courbe référencée 403 correspond à une capacité de 500pF.

Comme l'illustre la figure 4, la rapidité du dispositif d'interfaçage de sortie 200 de l'art antérieur diminue légèrement lorsque la charge capacitive en sortie augmente. En effet, si on compare la courbe 401 avec la courbe 403, on constate que ; avec une capacité de 500pF en sortie du dispositif, on met environ trois fois plus de temps pour passer de VCC à VSS.

Bien que cette solution de l'art antérieur ait représenté un progrès important dans le mécanisme de réduction de l'impact de la charge capacitive sur les performances dynamiques du dispositif d'interfaçage, la seconde technique connue présente toujours le désavantage d'être sensible aux fortes charges capacitives, en d'autres termes, plus la capacité en sortie augmente plus le temps de transition est ralentie.

### 3. Objectifs de l'invention

L'invention a notamment pour objectif de pallier ces inconvénients de l'art antérieur.

Plus précisément, un objectif de l'invention, dans au moins un de ses modes de réalisation, est de fournir une technique permettant de contrôler simplement et efficacement la pente maximale du signal de sortie d'un dispositif d'interfaçage de sortie.

Un autre objectif de l'invention, dans au moins un de ses modes de réalisation, est de fournir un tel système qui permette d'accélérer la pente maximale du signal de sortie, lorsque la capacité de la charge placée en sortie du dispositif augmente.

Il est à noter que la formulation de cet objectif est, en elle-même, nouvelle est inventive car l'homme du métier du domaine des dispositifs d'interfaçage de sortie n'a jamais envisagé d'obtenir une pente maximale du signal de sortie de plus en plus élevée, pour une charge capacitive de plus en plus forte.

L'invention, dans au moins un de ses modes de réalisation, a encore pour objectif de fournir un tel système qui génère un bruit réduit par rapport aux dispositifs d'interfaçage de sortie classiques.

L'invention, dans au moins un de ses modes de réalisation, a également pour objectif de fournir un tel système qui soit simple à réaliser et pour un faible coût.

### 4. Caractéristiques essentielles de l'invention

Ces objectifs, ainsi que d'autres qui apparaîtront par la suite, sont atteints à l'aide d'un dispositif d'interfaçage de sortie recevant en entrée un signal d'entrée et délivrant en sortie, à une charge externe, un signal de sortie.

Selon l'invention, le dispositif comprend des moyens d'inversion de l'effet de la capacité de la charge externe sur la pente (en Anglais « slew rate ») du signal de sortie. Les moyens d'inversion comprennent des moyens d'augmentation de la pente du signal de sortie. Le dispositif comprend des moyens d'initialisation desdits moyens d'augmentation, permettant d'initialiser lesdits moyens d'augmentation à chaque fois que ledit signal d'entrée commute entre un premier niveau et un second niveau.

Ainsi, l'invention repose sur une approche tout à fait nouvelle et inventive du contrôle de la pente du signal de sortie d'un dispositif d'interfaçage de sortie. En effet, l'invention propose d'utiliser des moyens d'inversion pour augmenter la rapidité du dispositif lorsque la charge capacitive en sortie augmente. En d'autres termes, selon l'invention, plus la charge capacitive augmente plus la pente maximale du signal de sortie augmente, en réponse à un échelon en tension appliqué en entrée du dispositif.

Ledit dispositif comprend des moyens de commutation dudit signal de sortie. Selon un aspect avantageux de l'invention, lesdits moyens d'inversion de l'effet de la capacité de la charge externe sur la pente du signal de sortie comprennent :
- des moyens de diminution de la pente du signal de sortie, permettant de retarder la commande desdits moyens de commutation, tant qu'un critère de commande prédéterminé n'est pas vérifié ; et
- des moyens d'augmentation de la pente du signal de sortie, permettant d'accélérer la commande desdits moyens de commutation, lorsque ledit critère de commande prédéterminé est vérifié.

Ainsi, l'invention propose d'associer des moyens de diminution et d'augmentation de la pente du signal de sortie. Ces moyens sont activés successivement, à savoir, tout d'abord les moyens de diminution sont activés tant qu'un critère prédéterminé n'est pas vérifié (par exemple si on est inférieur à un seuil de tension), puis lorsque le critère est vérifié, les moyens d'augmentation sont activés.

Ledit dispositif comprend des premier et deuxième transistors montés en grille et drain communs, de façon à former un premier inverseur. Dans un mode de réalisation préférentiel de l'invention, lesdits moyens de diminution de la pente du signal de sortie comprennent au moins un élément résistif monté entre le premier transistor et le deuxième transistor.

De façon avantageuse, lesdits moyens d'augmentation de la pente du signal de sortie comprennent des moyens de rebouclage de la sortie desdits moyens de commutation vers l'entrée desdits moyens de commutation.

Il est important de noter que les moyens de rebouclage créent dans le circuit une contre-réaction qui accélère la dynamique de commutation du circuit.

De façon préférentielle, lesdits moyens de rebouclage comprennent au moins un élément capacitif.

Avantageusement, le dispositif comprend des moyens de commande desdits moyens de rebouclage, permettant de bloquer lesdits moyens de rebouclage tant que ledit critère de commande prédéterminé n'est pas vérifié.

Préférentiellement, lesdits moyens de commande comprennent :
- un troisième transistor formant interrupteur et monté entre lesdits moyens de rebouclage et lesdits moyens de commutation ; et
- un second inverseur agissant sur ledit troisième transistor de sorte que :
   tant que ledit critère de commande prédéterminé n'est pas vérifié, alors ledit troisième transistor est placé dans un état bloqué.

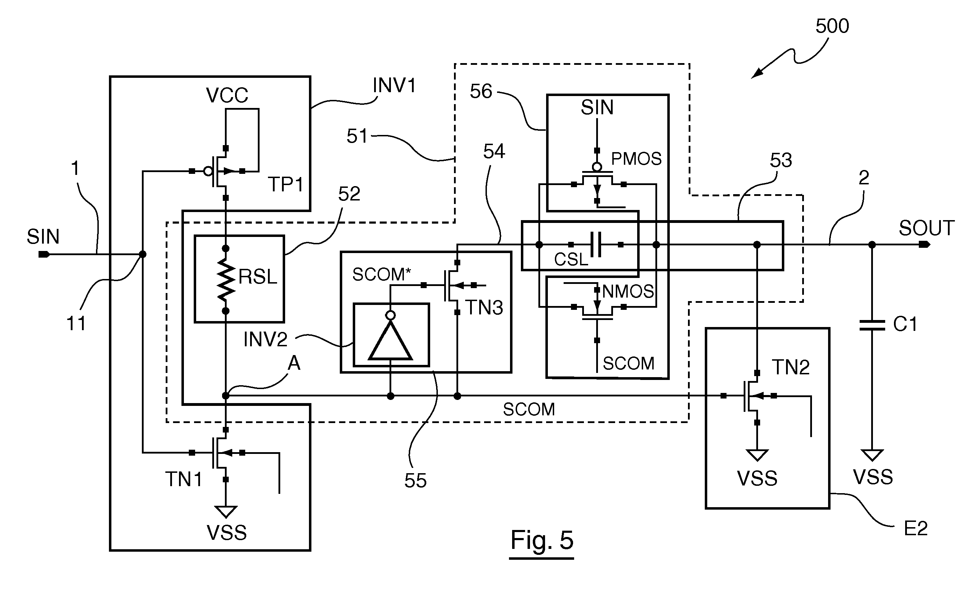

Ainsi, dés que l'inverseur (noté INV2 sur la figure 5) atteint son seuil (par exemple 1,5V), l'interrupteur se ferme (le troisième transistor TN3 est passant) et le potentiel de drain du transistor de sortie (noté TN2 sur la figure 5) est ramené sur sa grille.

Selon un aspect avantageux de l'invention, le dispositif comprend en outre des moyens d'initialisation desdits moyens de rebouclage, permettant d'initialiser lesdits moyens de rebouclage à chaque fois que ledit signal d'entrée commute entre un premier niveau et un second niveau.

Ainsi, les moyens d'initialisation permettent de décharger l'élément capacitif (utilisé pour le rebouclage) à chaque commutation du signal d'entrée (par exemple lorsque le signal d'entrée commute de VCC à VSS).

De façon préférentielle, lesdits moyens d'initialisation comprennent un quatrième transistor de type PMOS monté en source et drain communs avec un cinquième transistor de type NMOS.

L'invention concerne également un circuit électronique comprenant un dispositif d'interfaçage de sortie tel que décrit ci-dessus.

### 5. Liste des figures

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :
- la figure 1, déjà commentée en relation avec l'art antérieur, présente un schéma électrique d'un premier dispositif d'interfaçage classique ;
- la figure 2, également commentée en relation avec l'art antérieur, présente les performances du dispositif d'interfaçage de la figure 1 ;
- la figure 3, déjà commentée en relation avec l'art antérieur, présente un schéma électrique d'un second dispositif d'interfaçage classique ;
- la figure 4, également commentée en relation avec l'art antérieur, présente les performances du dispositif d'interfaçage de la figure 3 ;
- la figure 5 présente le schéma électrique d'un dispositif d'interfaçage selon un mode de réalisation préférentiel de l'invention ; et
- la figure 6 présente les performances du dispositif d'interfaçage de l'invention, pour trois valeurs de capacité en sortie.

### 6. Description d'un mode de réalisation de l'invention

Le principe général de l'invention repose sur la diminution et l'augmentation de la pente du signal de sortie d'un dispositif d'interfaçage.

Par souci de simplification de la description, on se limitera, dans toute la suite de ce document, à décrire le cas particulier d'un circuit d'interface de type NMOS. L'Homme du Métier étendra sans difficulté cet enseignement à tout autre type de circuit d'interface, notamment les circuits d'interface de type PMOS et « push-pull ».

On décrit en relation avec la figure 5 un dispositif d'interfaçage de sortie 500 selon un mode de réalisation préférentiel de l'invention.

Dans ce mode de réalisation, le dispositif d'interfaçage de sortie 500 selon l'invention comprend :
- un premier inverseur INV1, correspondant à l'étage E1 de commande décrit en relation avec la figure 1;
- un étage E2 de sortie classique en soi, comprenant un transistor de sortie TN2: et
- des moyens d'inversion 51 spécifiques à l'invention.

Par souci de clarté, l'architecture et le fonctionnement détaillés du premier inverseur INV1 ne sont pas décrits de nouveau ci-après.

A titre de rappel, ce premier inverseur INV1 est formé par un premier transistor TP1 et un deuxième transistor TN1, montés en grille et drain communs.

Le dispositif d'interfaçage de sortie 500 selon l'invention comprend une entrée 1 sur laquelle est appliqué un signal d'entrée SIN et une sortie 2 délivrant un signal de sortie SOUT à une charge externe C1 (qui est par exemple une capacité de 50 pF).

Comme illustré par la figure 5, les moyens d'inversion 51 de l'effet de la capacité de la charge externe sur la pente du signal de sortie comprennent :
- des moyens de diminution 52 de la pente du signal de sortie comprenant une résistance de contrôle RSL montée entre le drain du premier transistor TP1 et le drain du deuxième transistor TN1; et
- des moyens d'augmentation 53 de la pente du signal de sortie comprenant un rebouclage 54 du drain du transistor de sortie TN2 vers sa grille.

Comme on le verra par la suite, le rebouclage 54 crée une contre-réaction qui accélère la dynamique de commutation du dispositif.

Dans un mode de réalisation préférentiel de l'invention, le rebouclage est effectué via une capacité de contrôle CSL. On prévoit avantageusement, des moyens d'initialisation 56 pour décharger la capacité de contrôle CSL. Les moyens d'initialisation 56 comprennent un quatrième transistor de type PMOS monté en source et drain communs avec un cinquième transistor de type NMOS. Le quatrième transistor PMOS est commandé par le signal d'entrée SIN (qui est appliqué sur la grille du transistor), et le cinquième transistor NMOS est commandé par le signal de commande SCOM délivré par le premier inverseur INV1. Ainsi, à chaque commutation du signal d'entrée de VCC à VSS, les quatrième PMOS et cinquième NMOS transistors sont rendus passant, ce qui a pour effet de court-circuiter la capacité de contrôle CSL et donc de la décharger.

Dans le présent mode de réalisation, le dispositif d'interfaçage de sortie 500 selon l'invention comprend en outre des moyens de commande 55 permettant d'autoriser ou non le rebouclage.

Comme l'illustre la figure 5, les moyens de commande 55 comprennent :
- un second inverseur INV2 recevant en entrée le signal de commande SCOM et délivrant en sortie un signal de commande inversé SCOM*; et
- un troisième transistor TN3, dont la source est reliée à la grille du transistor de sortie TN2 et dont le drain est relié à une extrémité de la capacité de contrôle CSL, formant un interrupteur commandé par le signal de commande inversé SCOM* (appliquée sur la grille du transistor TN3).

On décrit ci-après en référence à la figure 5, le fonctionnement du dispositif d'interfaçage de sortie 500 selon l'invention, pour une commutation du signal d'entrée SIN de VCC à VSS. A titre d'exemple, on considère que le second inverseur INV2 bascule, c'est-à-dire délivre un signal de commande inversé SCOM* sensiblement égal à VCC, lorsque le signal d'entrée SIN est supérieur à 1,5V.

Lorsque le signal d'entrée SIN est supérieur ou égal à VSS et inférieur ou égal à 1,5V, la capacité de grille (non représentée) du transistor de sortie TN2 se charge à travers le signal de commande SCOM. La montée en tension du signal de commande SCOM est contrôlée (c'est-à-dire retardée) par la résistance de contrôle RSL. Ceci a pour conséquence de retarder la commande du transistor de sortie TN2, et donc de ralentir la vitesse de commutation du dispositif. Il est important de noter que, dans ce cas, le second inverseur INV2 délivre un signal de commande inversé SCOM* sensiblement égal à VSS. Le troisième transistor TN3 est donc rendu bloqué (interrupteur ouvert), ce qui a pour effet de désactiver la contre-réaction (pas de rebouclage). On note également que la résistance de contrôle RSL améliore l'immunité du dispositif vis-à-vis du bruit et/ou des perturbations électromagnétiques.

En revanche, lorsque le signal d'entrée SIN est supérieur à 1,5V et inférieur ou égal à VCC, le second inverseur INV2 délivre un signal de commande inversé SCOM* sensiblement égal à VCC, le troisième transistor TN3 est donc rendu passant (interrupteur fermé) et la contre-réaction activée. la capacité de grille (non représentée) du transistor de sortie TN2 se charge alors à travers le signal de sortie SOUT (qui est ramené par la capacité de contrôle CSL). Ceci a pour conséquence d'accélérer la commande du transistor de sortie TN2, et donc d'augmenter la vitesse de commutation du dispositif.

L'adjonction de la résistance de contrôle RSL avec la contre-réaction (capacité de contrôle CSL) permet d'inverser l'effet de la capacité de la charge externe C1 sur la pente (en Anglais « slew rate ») du signal de sortie SOUT.

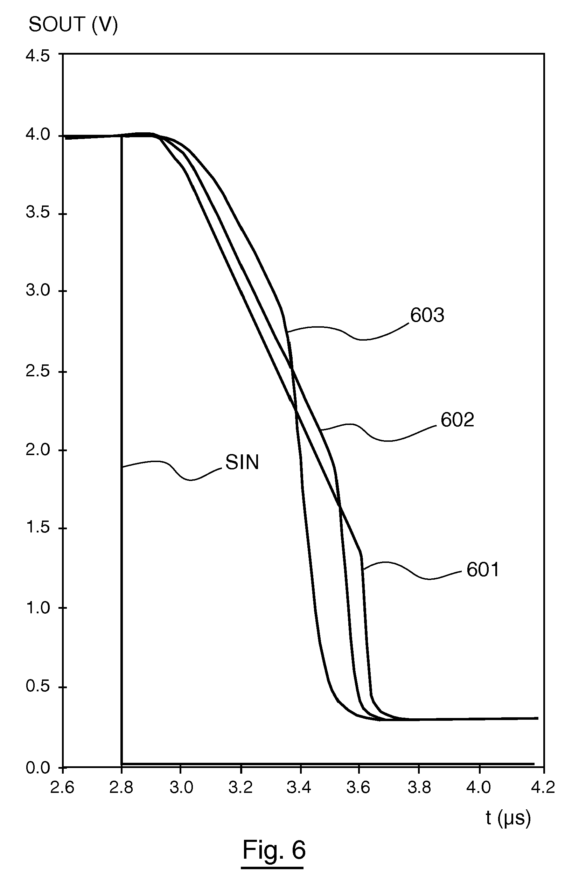

On présente désormais en relation avec la **figure 6**, les performances dynamiques (temps de descente du signal de sortie SOUT mesuré aux bornes de la capacité C1) du dispositif d'interfaçage de sortie 500 de l'invention (figure 5) en réponse à un signal d'entrée SIN sous la forme d'un échelon de tension passant d'une tension sensiblement égale à l'alimentation VCC (4V) à VSS (0V).

Plus précisément, la figure 6 présente trois courbes référencées 601 à 603 illustrant la tension (en volts) du signal de sortie SOUT en fonction du temps t exprimé en microsecondes (µs) pour trois valeurs de capacité C1. Ainsi, la courbe référencée 601 correspond à une capacité de 50pF, la courbe référencée 602 correspond à une capacité de 200pF et la courbe référencée 603 correspond à une capacité de 500pF.

Comme l'illustre la figure 6, la rapidité du dispositif d'interfaçage de sortie 500 de l'invention augmente lorsque la charge capacitive en sortie augmente. En effet, si on compare la courbe 601 avec la courbe 603, on constate que ; avec une capacité de 500pF en sortie du dispositif, on met environ deux fois moins de temps pour passer de VCC à VSS.

## Revendications

1. Dispositif d'interfaçage de sortie (500) recevant en entrée (1) un signal d'entrée (SIN) et délivrant en sortie (2), à une charge externe (C1), un signal de sortie (SOUT),
**caractérisé en ce qu'**il comprend des moyens d'inversion (51) de l'effet de la capacité de la charge externe (C1) sur la pente (en Anglais « slew rate ») du signal de sortie (SOUT), lesdits moyens d'inversion (51) comprenant des moyens d'augmentation (53) de la pente du signal de sortie,
et **en ce que** ledit dispositif comprend des moyens d'initialisation (56) desdits moyens d'augmentation (53), permettant d'initialiser lesdits moyens d'augmentation (53) à chaque fois que ledit signal d'entrée (SIN) commute entre un premier niveau et un second niveau.

2. Dispositif d'interfaçage selon la revendication 1, ledit dispositif comprenant des moyens de commutation (E2) dudit signal de sortie,
**caractérisé en ce que** lesdits moyens d'inversion (51) de l'effet de la capacité de la charge externe sur la pente du signal de sortie comprennent des moyens de diminution (52) de la pente du signal de sortie, permettant de retarder la commande desdits moyens de commutation (E2), tant qu'un critère de commande prédéterminé n'est pas vérifié.

3. Dispositif d'interfaçage selon la revendication 2, ledit dispositif comprenant des premier (TP1) et deuxième transistors (TN1) montés en grille et drain communs, de façon à former un premier inverseur (INV1),
**caractérisé en ce que** lesdits moyens de diminution (52) de la pente du signal de sortie comprennent au moins un élément résistif (RSL) monté entre le premier transistor (TP1) et le deuxième transistor (TN1).

4. Dispositif d'interfaçage selon l'une quelconque des revendications 1 à 3,
**caractérisé en ce que** lesdits moyens d'augmentation (53) de la pente du signal de sortie comprennent des moyens de rebouclage (54) de la sortie desdits moyens de commutation (E2) vers l'entrée desdits moyens de commutation.

5. Dispositif d'interfaçage selon la revendication 4, **caractérisé en ce que** lesdits moyens de rebouclage (54) comprennent au moins un élément capacitif (CSL).

6. Dispositif d'interfaçage selon l'une quelconque des revendications 1 à 5,
**caractérisé en ce qu'**il comprend des moyens de commande (55) desdits moyens de rebouclage (54), permettant de bloquer lesdits moyens de rebouclage (54) tant que ledit critère de commande prédéterminé n'est pas vérifié.

7. Dispositif d'interfaçage selon la revendication 6, **caractérisé en ce que** lesdits moyens de commande (55) comprennent :
- un troisième transistor (TN3) formant interrupteur et monté entre lesdits moyens de rebouclage (54) et lesdits moyens de commutation (E2) ; et
- un second inverseur (INV2) agissant sur ledit troisième transistor (TN3) de sorte que :
tant que ledit critère de commande prédéterminé n'est pas vérifié, alors ledit troisième transistor (TN3) est placé dans un état bloqué.

8. Dispositif d'interfaçage selon l'une quelconque des revendications 1 à 7,
**caractérisé en ce que** lesdits moyens d'initialisation (56) comprennent un quatrième transistor de type PMOS monté en source et drain communs avec un cinquième transistor de type NMOS.

9. Circuit électronique **caractérisé en ce qu'**il comprend un dispositif d'interfaçage de sortie selon l'une quelconque des revendications 1 à 8.
